# EUROPEAN PATENT APPLICATION

(11) **EP 1 858 088 A1**
(43) Date of publication of application: **21.11.2007**
(21) Application number: 06712371.1
(22) Date of filing: 26.01.2006
(51) Int. Cl.: H01L 33/00, H01L 21/20, H01L 21/205, H01L 21/338, H01L 29/778, H01L 29/812

(54) **NITRIDE SEMICONDUCTOR DEVICE AND METHOD OF GROWING NITRIDE SEMICONDUCTOR CRYSTAL LAYER**

(30) Priority: 27.01.2005 JP 2005019522
(71) Applicant: ROHM CO., LTD., Kyoto-shi, Kyoto 615-8585 (JP)
(72) Inventor: NAKAHARA, Ken, Kyoto-shi, Kyoto, 6158585 (JP); TAMURA, Kentaro, Kyoto-shi, Kyoto, 6158585 (JP)
(74) Representative: TBK-Patent
(86) International application number: PCT/JP2006/301189
(87) International publication number: WO 2006/080376

(57) **Abstract**

There are provided a nitride semiconductor device such as a nitride semiconductor light emitting device, a transistor device or the like, obtained by forming a buffer layer of a single crystal of the nitride semiconductor, in which both a-axis and c-axis are aligned, directly on a substrate lattice-mismatched with the nitride semiconductor without forming an amorphous low temperature buffer layer, and growing epitaxially the nitride semiconductor layer on the buffer layer of the single crystal. In this device, a single crystal buffer layer (2), made of a single crystal of AlₓGa_{y}In_{1-x-y}N (0≦x≦1, 0≦y≦1 and 0≦x+y≦1), in which a-axis and c-axis are aligned, is directly formed on a substrate (1) lattice-mismatched with nitride semiconductor, and a nitride semiconductor layer (3) is epitaxially grown on the buffer layer (2) of the single crystal. The buffer layer of the single crystal can be formed by the use of a PLD method.

## Description

### FIELD OF THE INVENTION

The present invention relates to a light emitting device such as a light emitting diode (LED), a laser diode or the like, using nitride semiconductor, a semiconductor device such as a transistor device or the like, like a HEMT or the like, using a nitride semiconductor crystal layer, and relates to a method for epitaxially growing a nitride semiconductor crystal layer. More particularly, the present invention relates to a method for growing a nitride semiconductor crystal layer excellent in a crystalline structure even in case of growing nitride semiconductor on a lattice-mismatched substrate with the nitride semiconductor, and relates to a nitride semiconductor device using the nitride semiconductor crystal layer.

### BACKGROUND OF THE INVENTION

Nitride semiconductor light emitting device such as a blue light emitting diode (LED), a laser diode or the like, using nitride semiconductor has been lately in practical use. A layer of the nitride semiconductor is usually grown on a lattice-mismatched substrate with the nitride semiconductor such as a substrate made of sapphire or SiC, because a GaN substrate for a homogeneous growth substrate is very expensive. Here, the lattice-mismatched substrate with nitride semiconductor means a substrate having a relationship represented by next inequality: (difference of lattice constants of an a-axis direction between nitride semiconductor and a substrate) / (a lattice constant of an a-axis direction of the nitride semiconductor) ≧ 0.5%. Therefore, there is known a method in which after forming a low temperature buffer layer made of an amorphous AlGaN based compound (which means that a mixed crystal ratio of Al and Ga can be varied variously and the same applies hereinafter) or the like, for example, on a sapphire substrate at a temperature lower than that of crystal growth, a nitride semiconductor crystal layer is epitaxially grown thereon at a high temperature of the crystal growth by an MOCVD method or the like.

In the method for growing the nitride semiconductor layer after providing the low temperature buffer layer, an amorphous AlGaN based compound layer is deposited at a temperature (for example, 500°C) lower than a crystal growth temperature (for example, 1020°C) required for forming a single crystal thin film of nitride semiconductor, then a temperature is raised to a suitable temperature for crystal growth, while growing the crystal by using a small crystallized nucleus formed when raising temperature as a seed, for example, in a same reaction furnace for the MOCVD method (cf. for example PATENT DOCUMENT 1). AS another method, there is also known a method in which an amorphous nitride semiconductor layer is formed (for example, 430°C) by a method such as a sputtering method not using organic metal compounds and in which a nitride semiconductor layer is grown after a heat treatment (for example, 1000 to 1250°C) in an atmosphere of mixed gas of hydrogen gas and ammonia gas (cf. for example PATENT DOCUMENT 2).
PATENT DOCUMENT 1: Japanese Patent Application Laid-Open No. HEI4-297023
PATENT DOCUMENT 2: Japanese Patent Application Laid-Open No. 2000-286202

### DISCLOSURE OF THE INVENTION

### PROBLEM TO BE SOLVED BY THE PRESENT INVENTION

As described above, as a nitride semiconductor crystal layer is grown on a lattice-mismatched substrate with nitride semiconductor in the prior art, the growth process is performed by steps of forming an amorphous low temperature buffer layer on a substrate, raising a temperature of the substrate to that of epitaxial growth, forming a nucleus crystallized in the low temperature buffer layer, and epitaxially growing a nitride semiconductor layer by using the nucleus as a seed. Therefor, since the nitride semiconductor layer is not epitaxially grown on a perfect single crystal layer at a high temperature, there arises a problem such that crystal defects easily occur in the nitride semiconductor layer grown thereon, and even if a light emitting device is formed, deterioration of internal quantum efficiency is easily caused by increasing of a threshold current or the like.

Further, if depositing the low temperature buffer layer and growing a high temperature epitaxial growth layer are carried out in the same reaction furnace, there is a merit such that the buffer layer and the epitaxial growth layer can be formed subsequently, because a crystal layer can be grown without taking out the substrate in air. However there is a problem such that a heating mechanism becomes large-scale and a heating apparatus becomes expensive because a structure which can control temperature of a wide range of approximately 200 to 1,100°C is required to the heating apparatus. Still further, in the above-described method of forming the low temperature buffer layer by sputtering, since particles having high energy of several tens eV are produced by self-bias generated on a target and damage the substrate, only a film having a special defect such as a void, a columnar structure or the like is formed, and a problem arises such that a nitride semiconductor layer excellent in a crystalline structure can not be epitaxially grown similarly because the defect appears in the nitride semiconductor layer grown on the buffer layer as a penetrating dislocation.

The present invention is directed to solve the above-described problems and an object of the present invention is to provide a nitride semiconductor device such as a nitride semiconductor light emitting device, a transistor device or the like, obtained by forming a buffer layer of a single crystal of the nitride semiconductor, in which both a-axis and c-axis are aligned, directly on a substrate lattice-mismatched with the nitride semiconductor (which includes a substrate, on the surface of which a nitride film is formed by a nitriding process or the like, and the same applies hereinafter) without forming an amorphous low temperature buffer layer, and growing epitaxially the nitride semiconductor layer on the buffer layer of the single crystal.

Another object of the present invention is to provide a method for growing a nitride semiconductor layer in which a single crystal layer of nitride semiconductor, in which both a-axis and c-axis are aligned, is formed directly on a substrate lattice-mismatched with nitride semiconductor, such as a sapphire substrate or the like.

### MEANS FOR SOLVING THE PROBLEM

The present inventors examined earnestly and repeatedly to grow epitaxially nitride semiconductor having less crystal defects and dislocations in case of laminating nitride semiconductor layers on a substrate lattice-mismatched with the nitride semiconductor and found that a single crystal layer, in which not only c-axis but also a-axis is aligned, can be obtained even using a substrate, such as sapphire, lattice-mismatched with nitride semiconductor by depositing floating materials sublimated on the substrate while leaving floating freely as in a PLD (Plasma Laser Deposition) method, and by raising a temperature of the substrate to approximately 500 to 1,000°C so that atoms deposited on the substrate can move freely. It was also found that a nitride semiconductor crystal layer having less crystal defects and dislocations can be grown epitaxially by forming a buffer layer of single crystal, in which both c-axis and a-axis are aligned, on a lattice-mismatched substrate, and growing a nitride semiconductor layer further by a vapor growth method such as an MOCVD method or the like.

Here, the nitride semiconductor means a compound of Ga of group III element and N of group V element or a compound (nitride) in which a part or all of Ga of group III element substituted by other element of group III element like Al, In or the like and/or a part of N of group V element substituted by other element of group V element like P, As or the like.

A nitride semiconductor device according to the present invention includes a substrate lattice-mismatched with nitride semiconductor and a nitride semiconductor layer grown on the substrate, wherein a buffer layer of single crystal made of AlₓGa_{y}In_{1-x-y}N (0≦x≦1, 0≦y≦1 and 0≦ x+y≦1), in which a-axis and c-axis of the AlₓGa_{y}In_{1-x-y}N are aligned, is directly formed on the substrate and the nitride semiconductor layer is epitaxially grown on the buffer layer of the single crystal.

Another aspect of a nitride semiconductor device according to the present invention includes a sapphire substrate, an aluminum nitride film formed on a surface of the sapphire substrate by a nitriding treatment, and a buffer layer of similar single crystal made of AlₓGa_{y}In_{1-x-y}N (0≦x≦1, 0≦y≦1 and 0≦x+y≦1), in which a-axis and c-axis of the AlₓGa_{y}In_{1-x-y}N are aligned, is directly formed on the aluminum nitride film, and a nitride semiconductor layer grown on the buffer layer, thereby a polarity of the nitride semiconductor layer grown by the PLD method or the like can be controlled and a Ga polarity film which is excellent electrical and optical property can be formed.

A nitride semiconductor light emitting device excellent in internal quantum efficiency can be obtained by growing the nitride semiconductor layer including a plural nitride semiconductor layers on the buffer layer of the single crystal and laminating the nitride semiconductor layers so as to form a light emitting layer of a light emitting diode or a laser diode. A high speed transistor of a small leakage current and high break down voltage can be obtained due to a good crystalline structure by laminating the nitride semiconductor layers so as to form a transistor.

A method for growing a nitride semiconductor crystal layer in which a nitride semiconductor crystal layer is grown on a substrate lattice-mismatched with nitride semiconductor, includes the steps of; growing a buffer layer of single crystal made of AlₓGa_{y}In_{1-x-y}N (0≦x≦ 1, 0≦y≦1 and 0≦x+y≦1), in which a-axis and c-axis of the AlₓGa_{y}In_{1-x-y}N are aligned, directly on the substrate, and growing epitaxially the nitride semiconductor crystal layer on the buffer layer of single crystal. Here, it is preferable that the buffer layer is grown while supplying any one of nitrogen gas, ammonia gas and nitrogen plasma in a chamber and while replenishing N.

It is preferable that a sapphire substrate is used for the substrate, and includes the steps of; forming a nitride film on a surface of the sapphire substrate by irradiating radical nitrogen produced by a plasma onto the sapphire substrate or annealing the sapphire substrate in a reactive gas atmosphere containing N, and growing the buffer layer of the single crystal on the nitride film, thereby a nitride semiconductor layer having a high mobility can be obtained by decreasing of residual carriers in nitride semiconductor.

The single crystal layer of the nitride semiconductor layer can be formed on a surface of the lattice-mismatched substrate by growing the buffer layer of single crystal by using the PLD method at a temperature of the substrate in a range from 500 to 1,000°C.

It is preferable to carry out a vapor growth of the nitride semiconductor crystal layer by using an MOCVD method or HVPE method, because a composition of a grown layer can be easily controlled strictly without exchanging a target every time when the composition of the grown layer is changed gradually.

A nitride semiconductor light emitting device can be obtained by laminating the nitride semiconductor single crystal layers so as to include an n-type layer and a p-type layer and form a light emitting layer, in the growing of the nitride semiconductor crystal layers performed by the method of any one of claims 5 to 9.

### EFFECT OF THE INVENTION

The nitride semiconductor layer is usually grown on a lattice-mismatched substrate such as sapphire, SiC or the like, but since the buffer layer of single crystal made of an AlGaInN based compound is provided directly on the surface of the substrate by the present invention, the nitride semiconductor layer grown thereon is epitaxially grown as a semiconductor layer having less crystal defects and dislocations and excellent in a crystalline structure. As a result, a nitride semiconductor layer having a high mobility of carriers can be obtained, decreasing of threshold voltage or significant improvement of internal quantum efficiency can be achieved in case of a semiconductor light emitting device, and properties of a leakage current and break down voltage can be improved in case of a transistor such as a HEMT or the like.

Further, according to the present invention, since a PLD method is employed for forming the nitride semiconductor layer (buffer layer) of single crystal on the surface of the substrate (which includes the surface of the nitride film in case that the nitride film formed on the surface of the substrate by nitriding the substrate), the buffer layer of nitride semiconductor single crystal excellent in a crystalline structure can be grown. In other words, in case of sputtering, as described above, although particles having high energy of several tens eV are produced by self-bias generated in a target and damage the substrate, by the PLD method, a component material of the target is deposited on the surface of the substrate by sublimating and floating the component material of the target by irradiating laser. Atoms floated by irradiation of laser deposited on the substrate without exceeding incident energy of laser because an acceleration electric field does not exist. Therefore, the single crystal layer, in which a-axis and c-axis are aligned spontaneously, is grown by raising a temperature of the substrate to a temperature at which component elements of the nitride semiconductor can move freely. As a result, the nitride semiconductor layer can be grown in a state of single crystal even on the surface of the substrate lattice-mismatched with the nitride semiconductor.

### BRIEF DESCRIPTION OF THE DRAWINGS

Fig. 1 is a cross-sectional view explaining an embodiment of the nitride semiconductor device according to the present invention.
Fig. 2 is a cross-sectional view explaining another embodiment of the nitride semiconductor device according to the present invention.
Fig. 3 is a conceptional figure showing an apparatus for forming a buffer layer of single crystal.
Fig. 4 is a cross-sectional view explaining a constitution of an LED formed by the method according to the present invention.
Fig. 5 is an explanatory view showing a constitution of a transistor formed by the method according to the present invention.

### EXPLANATION OF LTTERS AND NUMERALS

1: sapphire substrate
2: buffer layer of single crystal
3: nitride semiconductor crystal layer
4: aluminum nitride film
13: high temperature buffer layer
14: n-type layer
15: active layer
16: p-type layer
17: semiconductor lamination portion
18: conductive light transmitting layer
19: p-side electrode
20: n-side electrode

### THE BEST EMBODIMENT OF THE PRESENT INVENTION

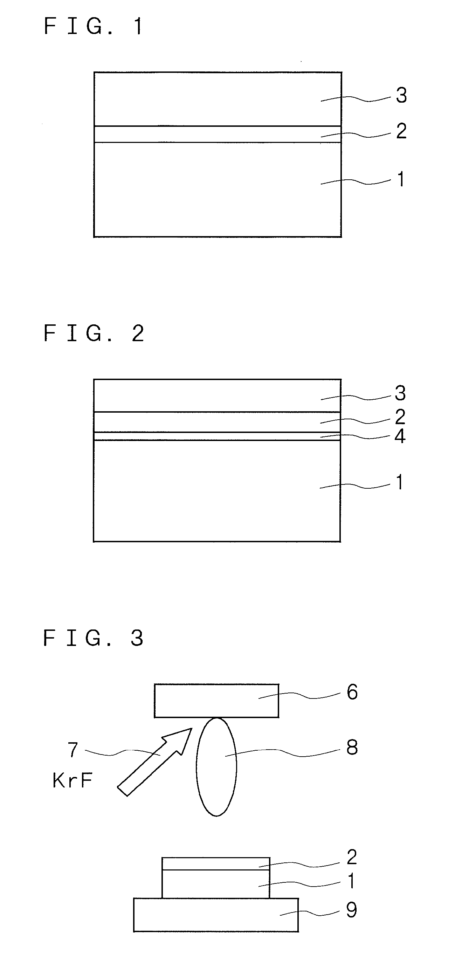

An explanation will be given below of a semiconductor device and a method for growing a nitride semiconductor crystal layer according to the present invention in reference to the drawings. As a cross-sectional view explaining an embodiment is shown in Fig. 1, the nitride semiconductor device according to the present invention is formed, in case of growing a nitride semiconductor layer 3 on a substrate 1 lattice-mismatched with nitride semiconductor, by forming a buffer layer 2 of single crystal of AlₓGa_{y}In_{1-x-y}N (0≦x≦1, 0≦y≦1 and 0≦x+y≦ 1), in which both a-axis and c-axis of the AlₓGa_{y}In_{1-x-y}N are aligned, directly on the substrate 1 and growing the nitride semiconductor layer 3 epitaxially on the buffer layer 2 of the single crystal.

Every kind of substrate made of a bulk substrate lattice-mismatched with nitride semiconductor, such as for example sapphire, SiC, Si, GaAs or the like, may be employed for the substrate 1. Namely, although a nitride semiconductor layer excellent in a crystalline structure can be epitaxially grown directly without forming such buffer layer of single crystal in case that the substrate is a GaN substrate, in case of a substrate except the GaN substrate, for example, lattice constants of a-axis of sapphire and GaN are different by approximately 14%, and even SiC is lattice-mismatched with GaN by approximately 3%, then any of them is not lattice-matched with the nitride semiconductor, the lattice-mismatching being far larger than 0.5%. The present invention is characterized in that a semiconductor layer excellent in a crystalline structure can be grown even using such lattice-mismatched substrate having a difference of 0.5% or more, and there exists significance in using such lattice-mismatched substrate with nitride semiconductor compound.

On the substrate 1, the buffer layer 2 of single crystal of AlₓGa_{y}In_{1-x-y}N (0≦x≦1, 0≦y≦1 and 0≦x+y≦1), in which both a-axis and c-axis of the AlₓGa_{y}In_{1-x-y}N are aligned, is formed directly. Namely, in a process of growing a nitride semiconductor layer by the prior art epitaxially on a substrate lattice-mismatched with nitride semiconductor, such as sapphire, SiC or the like, firstly, a low temperature buffer layer made of an amorphous nitride semiconductor layer is formed at a low temperature of approximately 400 to 500°C, thereafter, a nucleus is formed by raising a temperature to a high temperature of 600 °C or more, and the epitaxial growth is carried out using the nucleus as a seed. Though, the present invention is characterized in that the AlₓGa_{y}In_{1-x-y}N layer is grown in a state of single crystal directly on a surface of the substrate 1. The buffer layer 2 of a nitride semiconductor of single crystal may be formed with a nitride semiconductor layer easy to lattice-match with nitride semiconductor layers to be mainly grown for a device, such as GaN, AlGaN based compound, AlN, and InGaN based compound.

The buffer layer 2 of the nitride semiconductor of single crystal can be formed by a PLD method as described above. For example, as a conceptional view explaining the PLD method is shown in Fig. 3, the substrate 1 and a target 6 are arranged oppositely to each other in a vacuum chamber (not shown in the figure) whose inside pressure is 1×10⁻⁶ Torr or less, the substrate 1 is placed on a heat source 9. A temperature of the substrate is kept at high temperature of approximately 500 to 1,000°C, more preferably 700 to 900°C, and a laser light 7 of, for example, a KrF excimer laser having an oscillation wave length of 248 nm is radiated onto the target 6 through a quartz window of the vacuum chamber. Thereby a bloom 8 by sublimation (ablation) of a material of the target 6, is formed and sublimated atoms are deposited on a surface of the substrate 1 (therefore, the PLD method may be called a laser ablation method).

A sintered body made of, for example, GaN, AIN, AlGaN based compound, InGaN based compound or the like may be used for a target, generally a material can be decided depending on a component of the nitride semiconductor crystal layer to be grown on the buffer layer of single crystal in compositions of AlₓGa_{y}In_{1-x-y}N (0≦x≦1, 0≦y≦1 and 0≦x+y≦1). In this case, since In is a material difficult to make a compound, it is necessary to notice that a composition is easy to change. In case of forming a single crystal layer of GaN layer, a buffer layer of GaN single crystal can be grown by sublimating in a gas atmosphere of plasma gas of ammonia or nitrogen using Ga metal for a target, instead of using the sintered GaN for a target.

In case of growing the buffer layer of single crystal by using the sintered body, for example a sapphire substrate, in concrete, is set in a load lock chamber, and firstly extra water or the like is removed by heating at a temperature of approximately 400°C for approximately 5 to 10 min. Then the substrate 1 is transported into a chamber, and a temperature of the substrate is set to 700 to 900°C. When AlN is grown, the temperature of the substrate is preferably set approximately 100 to 200 °C higher than that in case of GaN. The GaN of the target 6 is sublimated and deposited on a surface of the sapphire substrate 1 by irradiating a KrF excimer laser beam 7 onto the target 6, and the buffer layer 2 of single crystal can be grown. The longer growth time can grow the thicker crystal layer by a thickness desired.

In this case, since GaN easily makes a nitrogen void, N is preferably replenished for forming a high quality film. As methods for replenishing N, there are a method of supplying nitrogen gas, that of supplying ammonia gas, and that of using nitrogen plasma. In using the nitrogen gas and ammonia gas, a flow rate of the gasses can be controlled by directly introducing into the chamber by using a mass flow controller and in using the nitrogen plasma, a radical cell activating gas by RF plasma is used. In any case, a pressure inside of the chamber is preferably suppressed not to be approximately 1×10⁻³ Torr or more (a degree of vacuum becomes bad).

A nitride semiconductor layer of single layer or multiple layers are formed so as to form a semiconductor device by a vapor growth method on the buffer layer of single crystal made of AlₓGa_{y}In_{1-x-y}N formed in the above manner. AS for the vapor growth method, although crystal growth by the PLD method is carried out continuously, an MOCVD (metal organic chemical vapor deposition) method or an HVPE (hydride vapor phase epitaxy) method, in which raw materials are easily exchanged in a same apparatus, is preferably used for laminating semiconductor layers of different composition especially such as in a semiconductor light emitting device, because targets are required to be exchanged every time in order to form semiconductor layers of different conduction types or of different compositions. Other vapor growth methods such as an MBE (molecular beam epitaxy) method, the PLD method or the like may be used.

The PLD method has a feature capable of growing a thin crystal film, since difference in composition between a target and thin film is small and particles having a high energy caused by self-bias are not generated. Furthermore, the PLD method can grow single crystal of the nitride semiconductor layer on the surface of the substrate lattice-mismatched with the nitride semiconductor without forming a low temperature buffer layer, since the PLD method is a kind of physical deposition and a GaN molecule exists in a sublimation material, so a film can be formed on a material such as a sapphire substrate not wettable for GaN, and since crystal growth can be carried out also while keeping an apparatus in high vacuum.

Fig. 2 is an explanatory cross-sectional view showing another embodiment of the nitride semiconductor device according to the present invention, similar to Fig. 1. In this example, a surface of the substrate is changed into a nitride surface by nitriding the surface of the sapphire substrate 1, and the buffer layer 2 of single crystal is grown through an aluminum nitride film 4. In concrete, in case that the substrate 1 is a sapphire substrate, the surface of the sapphire substrate 1 is changed into a single crystal layer of a thin AlN layer by heat treatment at a temperature of approximately 700 to 1,300°C in ammonia gas or by irradiating plasma nitrogen onto the sapphire substrate at a temperature of approximately 200°C.

If such AIN layer is formed on the surface of the substrate 1, a film quality can be improved because a polarity of a GaN layer or the like grown thereon can be controlled. Namely, the GaN layer is easy to be generally a Ga polarity in the MOCVD method, and this is preferable because of increase of mobility and reduction of residual carriers in this polarity. Though, in the PLD method, the GaN is easy to be an N polarity and a layer formed thereon is also easy to be an N polarity. But by forming an AIN film, a polarity of the GaN layer grown on the surface of the AIN film becomes a Ga polarity even by the PLD method and the GaN based compound layer formed thereon becomes the Ga polarity.

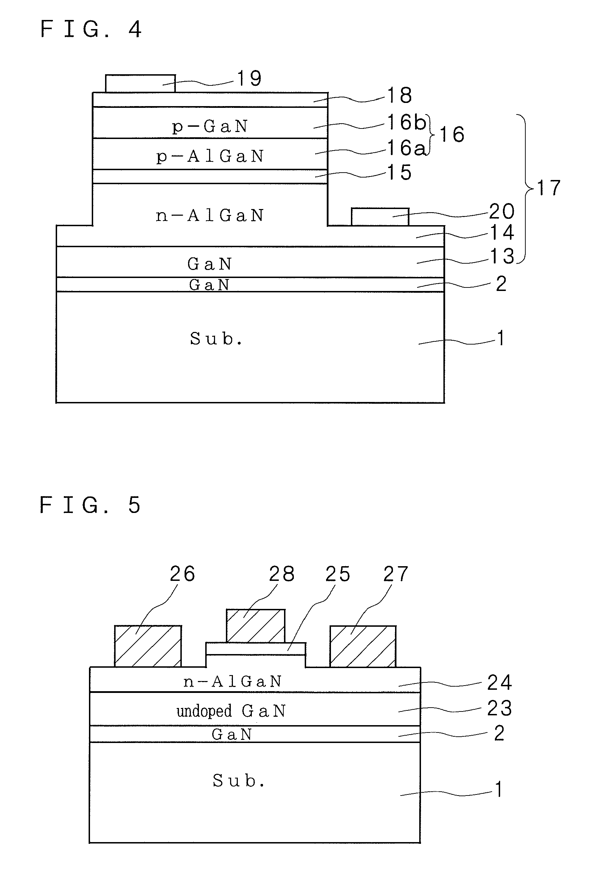

As a concrete example of the nitride semiconductor device, an example of a nitride semiconductor light emitting device will be subsequently explained below. In an example shown in Fig. 4 which is an example of a LED, a buffer layer 2 of single crystal made of un-doped GaN is grown on the sapphire substrate 1 by the above-described method. Thereafter, a semiconductor lamination portion 17 is formed by laminating following layers in order: a high temperature buffer layer 13 made of semi-resistive un-doped GaN and having a thickness of approximately 1 to 3 µm; an n-type layer 14 formed thereon, having a thickness of approximately 1 to 5 µm, made of AlGaN based compound semiconductor layer doped with Si which is a barrier layer (a layer with a large band gap energy); an active layer 15 formed in a thickness of approximately 0.05 to 0.3 µm, which has a structure of a multiple quantum well (MQW) formed by laminating 3 to 8 pairs of well layers made of for example In_{0.13}Ga_{0.87}N and having a thickness of 1 to 3 nm, and barrier layers made of GaN and having a thickness of 10 to 20 nm; and a p-type layer 16 formed with a p-type barrier layer (layer with a large band gap energy) 16a made of a p-type AlGaN based compound semiconductor and a contact layer 16b made of a p-type GaN, and having a thickness of approximately 0.2 to 1 µm in total.

A light transmitting conductive layer 18 which is formed of, for example, ZnO or the like and makes an ohmic contact with the p-type semiconductor layer 16 is formed in a thickness of approximately 0.01 to 0.5 µm on the semiconductor lamination portion 17. A member of this light transmitting conductive layer 18 is not limited to ZnO, and ITO (Indium Tin Oxide) or a thin alloy layer of Ni and Au having a thickness of approximately 2 to 100 nm can be used and diffuse current to whole part of a chip while transmitting light. Thereafter, a p-side electrode (upper electrode) 19 is formed on a part of a surface of the light transmitting conductive layer 18 with a lamination structure of Ti and Au, and an n-side electrode (lower electrode) 20 for a ohmic contact is formed with a Ti-Al alloy on the n-type layer 14 exposed by removing a part of the semiconductor lamination portion 17 by etching.

And the high temperature buffer layer may not be used, and although the n-type layer 14 and the p-type layer 16 are preferably provided with a layer including Al at a side of the active layer 15 with an aspect of carrier confinement effect, only the GaN layer may be used sufficiently or two kinds or more of multi-layers including other nitride semiconductor respectively can be employed. Although, in the above-described example, a double hetero junction structure is shown in which the active layer 15 is sandwiched by the n-type layer 14 and the p-type layer 16, a structure of a p-n junction can be used in which the n-type layer and the p-type layer are directly joined. Further, in the above-described example, although the buffer layer 2 of single crystal and the high temperature buffer layer 13 are formed un-doped because a sapphire substrate is used for the substrate, in case of using semiconductor such as SiC for the substrate 1, it is desirable to form them of same conductivity with that of the substrate, because one electrode can be extracted from a back surface of the substrate 1. And although the above-described example is an example of a LED, a laser diode can be formed by forming a light emitting region of a stripe shape in a similar manner.

In order to manufacture a semiconductor light emitting device having a structure shown in Fig. 4, after forming the buffer layer 2 of single crystal shown in Fig. 1, the substrate is set in an apparatus of metal organic chemical vapor deposition (MOCVD) and semiconductor layers having a desired composition and electric conductivity type can be formed in a desired thickness, by supplying necessary gasses such as a reactant gas like trimethyl gallium (TMG), ammonia (NH₃), trimethyl aluminum (TMA), trimethyl indium (TMI) or the like, and a dopant gas like SiH₄ for making an n-type, or a dopant gas like biscyclopentadienyl magnesium (Cp₂Mg), and growing in order at a high temperature of approximately 600 to 1,200°C.

Fig. 5 is a cross-sectional view explaining a transistor manufactured by using the method of forming the buffer layer of single crystal made of nitride semiconductor on the surface of the above-described substrate. In the same manner as a case of the light emitting device, the substrate 1 is set in the MOCVD apparatus, necessary organic metal gasses are supplied in the same manner as described above, there are formed, in order, an undoped GaN layer 23 approximately 4 µm thick, an electron transit layer 24 made of an n-type AlGaN based compound approximately 10 nm thick, an un-doped AlGaN based compound layer 25 approximately 5 nm thick, and the electron transit layer 24 is exposed by etching and removing the un-doped AlGaN based compound layer 25 leaving a part of a width of approximately 1.5 µm to be a gate length. And a transistor is constituted by forming a source electrode 26 and a drain electrode 27 made of for example Ti film and Au film on the electron transit layer 24 exposed by etching, and by forming a gate electrode 28 made of for example Pt film and Au film on a surface of the un-doped AlGaN based compound layer 25. The nitride semiconductor layers excellent in a crystalline structure can be formed and a transistor (HEMT) of a small leakage current and high break down voltage can be obtained, by growing such buffer layer 2 of single crystal on the surface of the substrate and growing GaN layers thereon.

A light emitting device using nitride semiconductor, such as an LED or a laser diode, and a transistor device such as a HEMT can be improved in characteristics and the nitride semiconductor device can be used in every kinds of electronic apparatus using the semiconductor device.

## Claims

1. A nitride semiconductor device comprising:
a substrate lattice-mismatched with nitride semiconductor, and
a nitride semiconductor layer grown on the substrate,
wherein a buffer layer of a single crystal made of AlₓGa_{y}In_{1-x-y}N (0≦x≦1, 0≦y≦1 and 0≦x+y≦1), in which a-axis and c-axis of the AlₓGa_{y}In_{1-x-y}N are aligned, is directly formed on the substrate and the nitride semiconductor layer is epitaxially grown on the buffer layer of the single crystal.

2. A nitride semiconductor device comprising:
a sapphire substrate, and
a nitride semiconductor layer grown on the sapphire substrate,
wherein an aluminum nitride film is formed on the sapphire substrate by a nitriding treatment, a buffer layer of a single crystal made of AlₓGa_{y}In_{1-x-y}N (0≦x≦1, 0≦y≦1 and 0≦x+y≦1), in which a-axis and c-axis of the AlₓGa_{y}In_{1-x-y}N are aligned, is directly formed on the aluminum nitride film, and the nitride semiconductor layer is epitaxially grown on the buffer layer of the single crystal.

3. The nitride semiconductor device according to claim 1 or 2, wherein the nitride semiconductor layer grown on the buffer layer of the single crystal comprises a plural nitride semiconductor layers, and the nitride semiconductor layers are laminated so as to form a light emitting layer of a light emitting diode or a laser diode, thereby a nitride semiconductor light emitting device is formed.

4. The nitride semiconductor device according to claim 1 or 2, wherein the nitride semiconductor layer grown on the buffer layer of the single crystal comprises a plural nitride semiconductor layers, and the nitride semiconductor layers are laminated so as to form a transistor.

5. A method for growing a nitride semiconductor crystal layer in which a nitride semiconductor crystal layer is grown on a substrate lattice-mismatched with nitride semiconductor, comprising the steps of:
growing a buffer layer of a single crystal made of AlₓGa_{y}In_{1-x-y}N (0≦x≦1, 0≦y≦1 and 0≦x+y≦1), in which a-axis and c-axis of the AlₓGa_{y}In_{1-x-y}N are aligned, directly on the substrate; and
growing epitaxially the nitride semiconductor crystal layer on the buffer layer of the single crystal.

6. The method for growing a nitride semiconductor crystal layer according to claim 5, wherein the buffer layer made of the AlₓGa_{y}In_{1-x-y}N is grown while supplying any one of nitrogen gas, ammonia gas and nitrogen plasma in a chamber and while replenishing N.

7. The method for growing a nitride semiconductor crystal layer according to claim 5 or 6, wherein a sapphire substrate is used for the substrate, further comprising steps of:
forming a nitride film on a surface of the sapphire substrate by irradiating radical nitrogen produced by a plasma onto the sapphire substrate or annealing the sapphire substrate in a reactive gas atmosphere containing N; and
growing the buffer layer of the single crystal on the nitride film.

8. The method for growing a nitride semiconductor crystal layer according to one of claims 5 to 7, wherein the buffer layer of the single crystal is grown at a temperature of the substrate in a range from 500 to 1,000 °C.

9. The method for growing a nitride semiconductor crystal layer according to one of claims 5 to 8, wherein the vapor growth of the nitride semiconductor crystal layer is carried out by using a MOCVD method or HVPE method.

10. A method for manufacturing a nitride semiconductor light emitting device, comprising the steps of laminating nitride semiconductor single crystal layers including an n-type layer and a p-type layer so as to form a light emitting layer,
wherein the growing of the nitride semiconductor crystal layers are performed by the method of one of claims 5 to 9.
